# EUROPEAN PATENT APPLICATION

(11) **EP 4 727 281 A1**
(43) Date of publication of application: **15.04.2026**
(21) Application number: 25168194.6
(22) Date of filing: 03.04.2025
(51) Int. Cl.: H10B 20/25, G11C 17/16, H01L 23/525

(54) **DUAL-ANTIFUSE DEVICES AND MEMORY STRUCTURES INCLUDING DUAL-ANTIFUSE DEVICES**

(30) Priority: 09.10.2024 US 202418910268
(71) Applicant: GlobalFoundries U.S. Inc., Malta, NY 12020 (US)
(72) Inventor: Raghavan, Ramesh, 500089 Narsingi Hyderabad (IN); Paul, Bipul C., Malta, 12020 (US); Chinthu, Siva Kumar, 560045 Bangalore (IN)
(74) Representative: Grünecker Patent- und Rechtsanwälte PartG mbB

(57) **Abstract**

Disclosed is a dual-antifuse (DAF) device with two electrically isolated antifuses. The DAF device includes a gate structure including a dielectric layer lining a recess in a semiconductor layer between first and second conductive regions and a conductor layer on the dielectric layer. A gate cut isolation structure extends through the conductor layer, dividing the conductor layer into first and second conductor sections. As a result, the device includes a first antifuse (i.e., the first conductor section, the first conductive region, and the dielectric layer therebetween) and a second antifuse (i.e., a second conductor section, the second conductive region, and the dielectric layer therebetween), which is isolated from the first antifuse. Thus, the two antifuses are independently programable. Also disclosed herein are memory structure embodiments, which include DAF devices (either with or without electrically isolated antifuses) integrated into the cells of an array and which are configured for improved reliability.

## Description

### BACKGROUND

The present disclosure relates to one-time programmable (OTP) memories and, more particularly, to embodiments of dual-antifuse devices and memory structures including dual-antifuse devices.

Goals of modern integrated circuit design include, but are not limited to, improving performance, reducing area, and reducing power consumption. Oftentimes design changes with respect to one of these goals can result in an undesirable trade-off with respect to one or more of the other goals. For example, memory structures that include one-time programmable (OTP) memory cells are often employed for applications when data needs to be reliably retained during repeated power on and power off cycles. Conventional OTP memory cells include devices, such as fuses or antifuses. Dual-antifuse (DAF) devices have also been developed to reduce memory structure area. The DAF devices include two antifuses. Typically, these two antifuses will have a common first terminal and discrete second terminals. Within a memory structure, the common first terminal may be connected to a wordline and the discrete second terminals may be connected to different bitlines. Unfortunately, results of reading and/or programming operations directed to selected antifuses within DAF devices in such a memory structure may be less reliable (e.g., due to IR drops caused by shorts within the array).

### SUMMARY

Disclosed herein are embodiments of a structure and, particularly, a dual-antifuse (DAF) device that includes two electrically isolated antifuses. Also disclosed herein are memory structure embodiments, which are configured for improved reliability and which include DAF devices (either with or without electrically isolated antifuses) that are integrated into an array of cells.

More particularly, disclosed herein are embodiments of a structure (e.g., a DAF device with two electrically isolated antifuses). The structure can include a semiconductor layer having a top surface and a recess in the top surface. The structure can further include a trench isolation structure in the semiconductor layer below the recess and a gate structure on the trench isolation structure. The gate structure can include a dielectric layer lining the recess and, on the dielectric layer, a first conductor section and a second conductor section positioned laterally adjacent and isolated from the first conductor section. In some embodiments, the structure can include first and second conductive regions in the semiconductor layer on either side of the recess, thereby creating two antifuses (i.e., a first antifuse and a second antifuse). The first antifuse can include the first conductor section, the first conductive region, and a first portion of the dielectric layer between the first conductor section and the first conductive region. The second antifuse can include the second conductor section, the second conductive region, and a second portion of the dielectric layer between the second conductor section and the second conductive region.

Also disclosed herein are embodiments of a memory structure that includes multiple DAF devices, such as the DAF device disclosed herein, with two electrically isolated antifuses. In these embodiments, the two antifuses of each DAF device are shared between different cells in an array (e.g., shared between adjacent cells in the same column of the array). Specifically, in these embodiments, the memory structure can include: an array of cells arranged in rows and columns; wordlines for the rows, respectively; bitlines for the columns, respectively; and multiple DAF devices integrated within the cells. Each cell in the array can include a pass gate transistor and only one antifuse of the two antifuses of a given DAF device. The one antifuse within the cell can be connected between a wordline for a row and the pass gate transistor. The pass gate transistor can be connected between the one antifuse and a bitline for a column and can have a gate that is also connected to the wordline for the row.

Also disclosed herein are embodiments of a memory structure that includes multiple DAF devices, each with two electrically connected antifuses. In these embodiments, the two antifuses of each DAF device are within the same cell but only one is operable (i.e., programmable and readable). Specifically, in these embodiments, the memory structure can include: an array of cells arranged in rows and columns; wordlines for the rows, respectively; bitlines for the columns, respectively; and multiple DAF devices integrated within the cells. Each cell can include a pass gate transistor and also a DAF device. A first antifuse of the DAF device can include a first terminal, which is connected between a wordline for a row, and a second terminal, which is connected to the pass gate transistor. The pass gate transistor can be connected between the first antifuse and a bitline for a column and can have a gate connected to the wordline for the row. A second antifuse of the DAF device can have a first terminal, which is shared with the first antifuse and, thus, connected to the wordline for the row, and a second terminal, which is either floated (i.e., not electrically connected to any other component) or connected to other second terminals of other second antifuses of other dual-antifuse devices of other cells. Thus, in each cell, the second antifuse of the DAF device is effectively left inoperable.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1A is a cross-section diagram of a dual-antifuse (DAF) device with two electrically connected antifuses;
FIG. 1B is a cross-section diagram illustrating embodiments of a DAF device with two electrically isolated antifuses;
FIGs. 2.1-2.6 are cross-section diagrams illustrating exemplary processes for forming the DAF device of FIG. 1A and for partially completing the DAF device of FIG. 1B;
FIGs. 2.7 is a cross-section diagram further illustrating additional processes that can be employed to complete the DAF device of FIG. 1B;
FIG. 3 is schematic diagram illustrating disclosed embodiments of a memory structure including DAF devices with two electrically isolated antifuses;
FIG. 4 is a diagram illustrating in greater detail two adjacent cells in the memory structure of FIG. 3;
FIGs. 5A and 5B are diagrams illustrating alternative layouts, respectively, for cells within the memory structure of FIG. 3;
FIG. 6 is a table illustrating example biasing conditions that can be employed during operation of the memory structure of FIG. 3;
FIG. 7 is schematic diagram illustrating disclosed embodiments of a memory structure including DAF devices with two electrically connected antifuses;
FIG. 8 is a diagram illustrating in greater detail a cell in the memory structure of FIG. 7; and
FIG. 9 is a table illustrating example biasing conditions that can be employed during operation of the memory structure of FIG. 7.

### DETAILED DESCRIPTION

As mentioned above, conventional OTP memory cells include devices, such as fuses or antifuses. Dual-antifuse (DAF) devices have also been developed to reduce memory structure area. The DAF devices include two antifuses. Typically, these two antifuses will have a common first terminal and discrete second terminals. Within a memory structure, the common first terminal may be connected to a wordline and the discrete second terminals may be connected to different bitlines. Unfortunately, results of reading and/or programming operations performed in such a memory structure may be less reliable (e.g., due to IR drops caused by shorts within the array).

In view of the foregoing, disclosed herein are embodiments of a dual-antifuse (DAF) device with two electrically isolated antifuses. Specifically, the DAF device can include a gate structure. The gate structure can include a dielectric layer lining a recess in a semiconductor layer between two conductive regions and a conductor layer on the dielectric layer. A gate cut isolation structure can extend through the conductor layer, thereby dividing it into a first conductor section and a second conductor section. As a result, the DAF device includes a first antifuse (i.e., the first conductor section, the first conductive region, and a first portion of the dielectric layer between the first conductor section and the first conductive region) and a second antifuse (i.e., a second conductor section, the second conductive region, and a second portion of the dielectric layer between the second conductor section and the second conductive region), which is electrically isolated from the first antifuse. Also disclosed herein are various memory structure embodiments that include DAF devices and that are configured to avoid IR drops caused by shorts and thereby to improve reliability. In some embodiments, the DAF devices can have electrically isolated antifuses, as in the DAF device disclosed herein. In these embodiments, the two antifuses of a DAF device can be incorporated into two different cells, respectively, located in adjacent rows in the same column. As discussed in greater detail below, by incorporating the two antifuses of each DAF device into two different cells, the wordline and bitline bias conditions required for programming or read operations can be achieved without causing shorts and IR drops that possibly lead to reliability issues. In other embodiments, the DAF devices can have electrically connected antifuses (e.g., due to a common terminal). In these embodiments, each cell includes a DAF device but only a first antifuse of the two antifuses is connectable to a bitline through a pass gate transistor. Thus, in these embodiments, only the first antifuse is programmable or readable and the wordline and bitline bias conditions required for programming or read operations with respect to that first antifuse can be achieved without causing shorts and IR drops that could possibly lead to reliability issues.

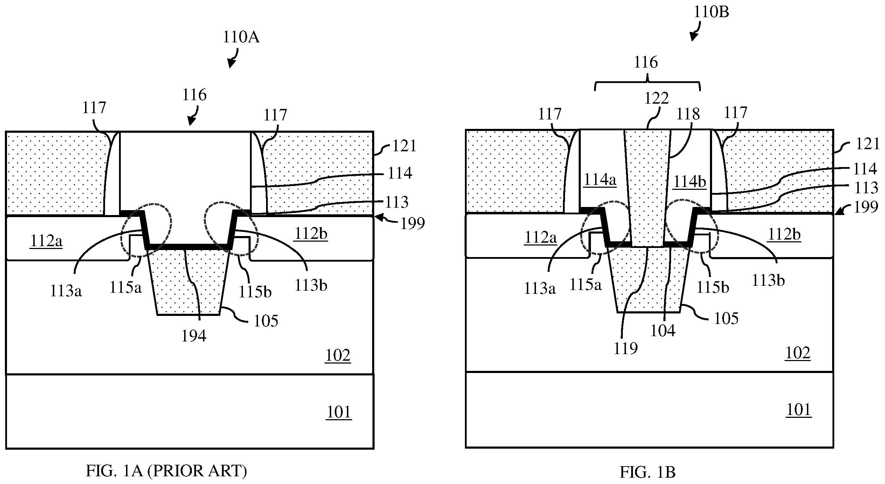

FIG. 1A is a cross-section diagram illustrating one example of a DAF device 110A including two antifuses 115a and 115b, where the two antifuses 115a and 115b are electrically connected by a common first terminal. FIG. 1B is a cross-section diagram illustrating disclosed embodiments of a DAF device 110B similarly including two antifuses 115a and 115b but where the two antifuses 115a and 115b are electrically isolated, as discussed in greater detail below.

More specifically, referring to FIGs. 1A-1B. DAF device 110A, 110B can be on a semiconductor layer 101. Semiconductor layer 101 can be, for example, a monocrystalline silicon substrate or, alternatively, a monocrystalline substrate of any other suitable semiconductor material (e.g., silicon germanium, etc.). That is, DAF device 110A, 110B could be a bulk semiconductor structure, as illustrated. Alternatively, semiconductor layer 101 could be a semiconductor layer of a semiconductor-on-insulator structure.

Semiconductor layer 101 can include a first surface (a bottom surface) and a second surface 199 (a top surface) opposite the first surface. DAF device 110A, 110B can further include, within semiconductor layer 101 adjacent to the top surface 199, a first conductive region 112a (also referred to herein as a first diffusion region) and a second conductive region 112b (also referred to herein as a second diffusion region) positioned laterally adjacent but physically separated from the first conductive region 112a. First and second conductive regions 112a-112b can have a first type conductivity. First and second conductive regions 112a-112b within semiconductor layer 101. For example, first and second conductive regions 112a-112b can be doped so as to have N-type conductivity at a relatively high conductivity level. As illustrated, first and second conductive regions 112a-112b can be within a well region 102. For purposes of this disclosure, a well region refers to a region of semiconductor material doped (e.g., via a dopant implantation process or any other suitable doping process) so as to have a particular conductivity type. Well region 102 can have a different type conductivity than first and second conductive regions 112a-112b. For example, if first and second conductive regions 112a-112b are N-type conductive regions, then well region 102 can be a P-type well region (Pwell) so the first and second conductive regions 112a-112b are electrically isolated from each other.

A trench isolation structure 105 (e.g., a shallow trench isolation (STI) structure) can be positioned laterally between and immediately adjacent to first and second conductive regions 112a-112b. Trench isolation structure 105 can include a trench, which extends into well region 102 and which is filled with one or more layers of isolation material (e.g., silicon dioxide, silicon nitride, silicon oxynitride, etc.). As illustrated, the bottom of trench isolation structure 105 can be at a depth greater than the depth of the bottoms of first and second conductive regions 112a-112b but above the bottom of well region 102. Additionally, the top of trench isolation structure 105 can be at a level lower than the top surface of semiconductor layer 101. That is, the DAF device 110A, 110B can include a recess 104 in the top surface of semiconductor layer 101 aligned above and extending to trench isolation structure 105. Thus, a bottom of the recess 104 exposes isolation material at the top of trench isolation structure 105 and opposing side surfaces of the recess 104 expose semiconductor material of the first and second conductive regions 112a-112b, respectively.

A gate structure 116 can be above and immediately adjacent to trench isolation structure 105. Gate structure 116 can include a dielectric layer 113. Dielectric layer 113 can include one or more layers of gate dielectric material. Gate dielectric material can include, but is not limited to, silicon dioxide, a high-k dielectric material (i.e., a material having a dielectric constant (k) that is greater than the dielectric constant of silicon dioxide, such as k>3.9), or any suitable dielectric material. Dielectric layer 113 can conformally line the bottom and opposing side surfaces of the recess 104 and can further extend laterally onto the top surface 199 of semiconductor layer 101 (e.g., partially over first and second conductive regions 112a-112b). Gate structure 116 can also include a conductor layer 114 on dielectric layer 113. Conductor layer 114 can include one or more layers of gate conductor material. Gate conductor material can include, for example, a conductive polycrystalline semiconductor material (e.g., doped polysilicon or a doped layer of some other suitable polycrystalline semiconductor material), metallic layer (e.g., a metal or metal alloy material layer), or some other suitable conductive material. Thus, gate structure 116 can include a narrow section within the recess above trench isolation structure 105 and positioned laterally between and immediately adjacent first and second conductive regions 112a-112b and a wide section above the narrow section. It should be noted that in embodiments where conductor layer 114 is a polycrystalline semiconductor layer (e.g., a polysilicon layer), conductor layer 114 can be doped so as to have the same first type conductivity as the first and second conductive regions 112a-112b. For example, conductor layer 114 can be doped so as to have N+ conductivity. In any case, dielectric gate sidewall spacers 117 can be on the top surface of semiconductor layer 101 above the first and second conductive regions 112a-112b and positioned laterally adjacent to opposing sidewalls of the wide section of gate structure 116. Such gate sidewall spacer structures are well known in the art and, thus, the details thereof have been omitted from this specification in order to allow the reader to focus on the salient aspects of the disclosed embodiments.

Referring to FIG. 1A, within DAF device 110A, first antifuse 115a includes conductor layer 114, first conductive region 112a, and a first portion 113a of dielectric layer 113 between conductor layer 114 and first conductive region 112a. Second antifuse 115b includes conductor layer 114, second conductive region 112b, and a second portion 113b of dielectric layer 113 between conductor layer 114 and second conductive region 112b. Thus, conductor layer 114 is a common first terminal between first and second antifuses 115a-115b, first conductive region 112a is the second terminal 112a of first antifuse 115a, and second conductive region 112b is the second terminal of second antifuse 115b.

Referring to FIG. 1B, in addition to the features described above, DAF device 110B can include a gate cut isolation structure 119. Gate cut isolation structure 119 can include a trench 118, which extends vertically through conductor layer 114 of gate structure 116, thereby dividing conductor layer 114 into two discrete and physically separated sections (i.e., a first conductor section 114a and a second conductor section 114b). Gate cut isolation structure 119 can further include one or more layers of isolation material 122 (e.g., silicon dioxide, silicon nitride, silicon oxynitride, etc.) filling trench 118 so that first conductor section 114a is electrically isolated from second conductor section 114b. Thus, in this DAF device 110B, first antifuse 115a includes first conductor section 114a, first conductive region 112a, and a first portion 113a of dielectric layer 113 between first conductor section 114a and first conductive region 112a. Second antifuse 115b includes second conductor section 114b, second conductive region 112b, and a second portion 113b of dielectric layer 113 between second conductor section 114b and second conductive region 112b. Thus, in DAF device 110B, there is no common terminal between first and second antifuses 115a and 115b. First conductor section 114a and first conductive region 112a are the first and second terminals, respectively, of first antifuse 115a. Second conductor section 114b and second conductive region 112b are the first and second terminals, respectively, of second antifuse 115b.

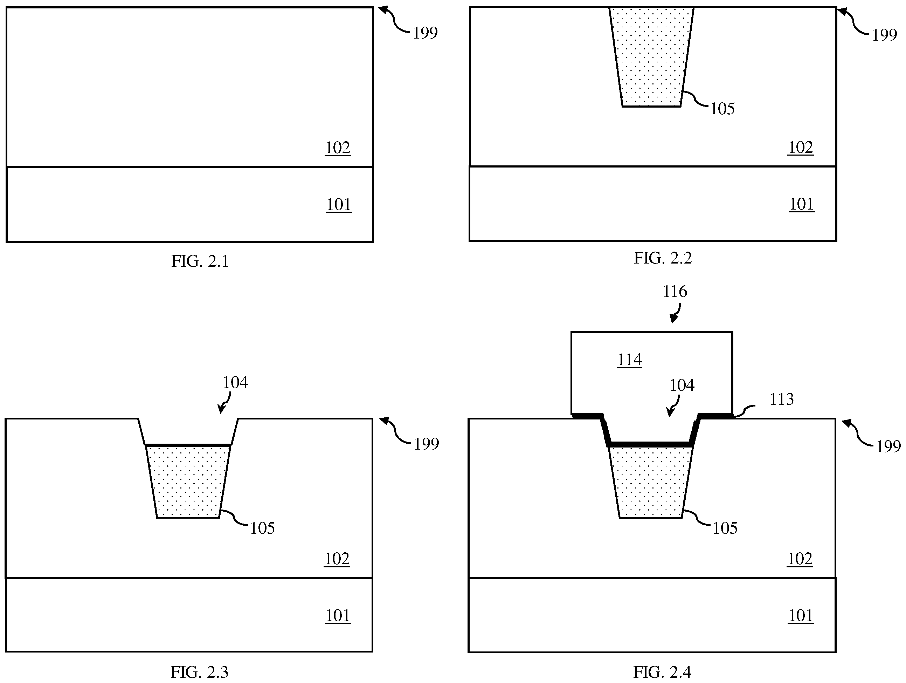

Also disclosed herein are method embodiments for forming the DAF device 110B of FIG. 1B. Specifically, the methods can include providing a semiconductor layer 101. Semiconductor layer 101 could be a bulk semiconductor structure, as illustrated, or a semiconductor layer of a semiconductor-on-insulator structure (see FIG. 2.1). Additionally, a well region 102 (e.g., a Pwell) can be formed in semiconductor layer 101 adjacent to the top surface (e.g., using a masked dopant implantation process).

A trench isolation structure 105 can be formed in the top surface 199 of semiconductor layer 101 and, particularly, within well region 102 (see FIG. 2.2). In some embodiments, trench isolation structure 105 can be formed using conventional shallow trench isolation (STI) formation techniques. That is, a trench can be formed (e.g., lithographically patterned and etched) into semiconductor layer 101. Then, one or more layers of isolation material (e.g., silicon dioxide, silicon nitride, silicon oxynitride, etc.) can be deposited so as to fill the trench. Next, a polishing process (e.g., a conventional chemical mechanical polishing (CMP) process) can be performed remove any isolation material from the top surface of semiconductor layer 101 outside the trench. Formation techniques for STI structures are well known in the art and, thus, more specific details thereof have been omitted from this specification in order to allow the reader to focus on the salient aspects of the disclosed embodiments.

Isolation material of trench isolation structure 105 can subsequently be etched back (e.g., using a timed selective etch process) (see FIG. 2.3). As a result, a recess 104 is formed at the top surface of semiconductor layer 101, aligned above a remaining lower portion of isolation material within the trench. Alternatively, any other suitable technique could be employed to form the structure with a recess 104 above a trench isolation structure. For example, techniques could be employed to fill the trench only partially with isolation material during trench isolation structure formation, thereby avoiding the need to perform the CMP and subsequent etch back. In any case, in the resulting recess 104, semiconductor material of semiconductor layer 101 is exposed at the opposing side surfaces of recess 104and isolation material is exposed at the bottom of recess 104.

A gate structure 116 can then be formed to include a lower portion in recess 104 and an upper portion above and wider than recess 104 (see FIG. 2.4). For example, a dielectric layer 113 can be formed over the partially completed structure. Dielectric layer 113 can include one or more layers of gate dielectric material. Gate dielectric material can include, but is not limited to, silicon dioxide, a high-k dielectric material (i.e., a material having a dielectric constant (k) that is greater than the dielectric constant of silicon dioxide, such as k>3.9), or any suitable dielectric material. In any case, dielectric layer 113 can be formed (e.g., conformally deposited) so as to line the bottom and opposing side surfaces of recess 104 and further over the top surface of semiconductor layer 101. A conductor layer 114 can then be formed on gate dielectric layer 113. Conductor layer can include one or more layers of gate conductor material. Gate conductor material can include, for example, a conductive polycrystalline semiconductor material (e.g., polysilicon or a layer of some other suitable polycrystalline semiconductor material), a metal or metal alloy material, or some other suitable conductive material. The gate dielectric-gate conductor material stack can subsequently be lithographically patterned and etch to form gate structure 116, which includes a narrow section that is within recess 104 above trench isolation structure 105 and positioned laterally between and immediately adjacent semiconductor surfaces and a wide section above the narrow section. Techniques for forming gate structures are well known in the art and, thus, more specific details thereof have been omitted from this specification in order to allow the reader to focus on the salient aspects of the disclosed embodiments.

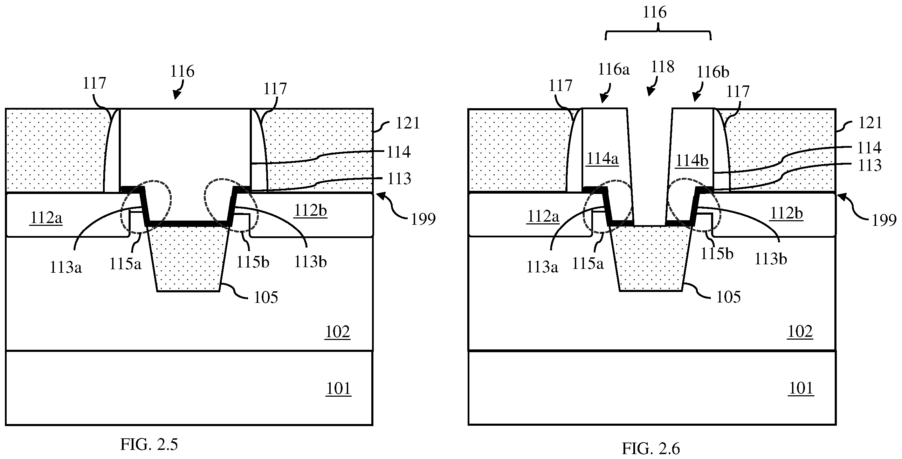

Next, dielectric gate sidewall spacers 117 can be formed on opposing sidewalls of gate structure 116 (e.g., using conventional sidewall spacer formation techniques). Additionally, at least one dopant implantation process can be performed to yield first and second conductive regions 112a-112b within well region 102 on either side of gate structure 116 (see FIG. 2.5). It should be understood that, if conductor layer 114 is a polycrystalline semiconductor layer (e.g., a polysilicon layer) and if it was not in situ doped when deposited, the same dopant implantation process used to form first and second conductive regions 112a-112b can also concurrently dope conductor layer 114 so it has the same conductivity type as the first and second conductive regions 112a-112b. In some embodiments, this dopant implantation process can be performed so that first and second conductive regions 112a-112b (and conductor layer 114, if applicable) have N-type conductivity at a relatively high conductivity level. One or more layers of interlayer dielectric (ILD) material 121 can subsequently be deposited over the partially completed structure. Optionally, a CMP process can be performed to expose gate structure 116.

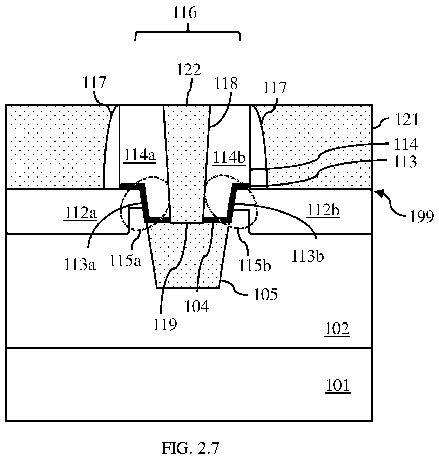

In addition to the processes described above and illustrated in FIGs. 2.1-2.5, formation of DAF device 110B of FIG. 1B can include formation of a gate cut isolation region 119 in gate structure 116. This gate cut isolation structure 119 can extend vertically through conductor layer 114 of gate structure 116 so as to divide it into a first conductor section 114a and a second conductor section 114b, which is electrically isolated from the first conductor section 114a. For purposes of illustration, formation of gate cut isolation structure 119 is shown in the figures (see FIGs. 2.6-2.7) as being performed following gate sidewall space formation and further following first and second conductive regions 112a-112b formation. For example, in some embodiments, a CMP process can be performed to expose gate structure 116. Gate cut isolation structure 119 can then be formed using techniques similar to those for forming STI structures following processing as shown in FIG. 2.5. That is, a trench 118 can be formed (e.g., lithographically patterned and etched) such that it extends completely through conductor layer 114, dividing it into the two discrete conductor sections 114a and 114b (see FIG. 2.6). Then, one or more layers of isolation material 122 (e.g., silicon dioxide, silicon nitride, silicon oxynitride, etc.) can be deposited so as to fill the trench 118. Another CMP process can be performed so that the top surfaces of the gate cut isolation structure 119 and the first and second conductor sections 114a-114b are essentially co-planar (see FIG. 2.7). It should, however, be understood that the figures are not intended to be limiting. Alternatively, gate cut isolation structure 119 could be formed using a similar technique as described above prior to formation of the first and second conductor sections 114a-114b. Alternatively, gate cut isolation structure 119 could be formed (again using a similar technique to that described above) but prior to gate structure patterning.

Additional processing can include, but is not limited to, conventional middle of the line (MOL) and back end of the line (BEOL) processing to provide electrical connections to one or more of the terminals of the antifuses (e.g., depending upon the design of the structure, such as the memory structure, which will incorporate the DAF device). Those skilled in the art will recognize that formation of DAF device 110A can include essentially the same processes described above for formation of DAF device 110B, except for those processes required for gate cut isolation region formation as shown in FIGs. 2.6 and 2.7.

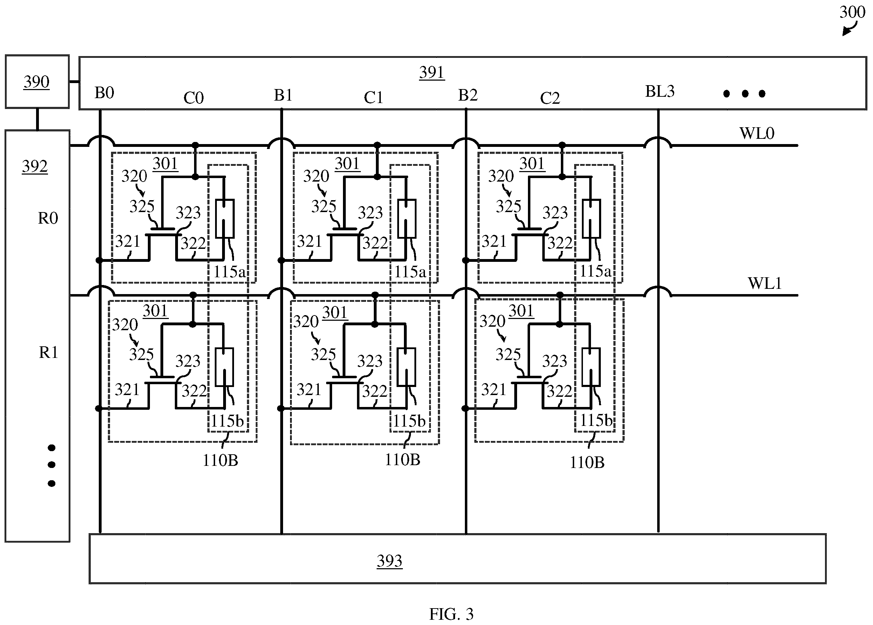

FIG. 3 is a schematic diagram illustrating disclosed embodiments of a memory structure 300, which includes multiple DAF devices 110B each having two electrically isolated antifuses (as described above and illustrated in FIG. 1B). In these embodiments, the two antifuses of each DAF device are included in two different cells in an array of cells within the memory structure (e.g., included in adjacent cells in the same column) and are individually and selectively programmable and readable without experiencing the reliability issues exhibited in prior art memory structures.

Specifically, memory structure 300 can include: an array of memory cells 301 (hereinafter referred to as cells) arranged in rows (e.g., R0, R1, etc.) and columns (e.g., C0, C1, C2, etc.). Memory structure 300 can further include wordlines (e.g., W0, W1, etc.) for the rows, respectively; bitlines (e.g., BL0, BL1, BL2, etc.) for the columns, respectively; and multiple DAF devices 110B integrated into cells 301, as described in greater detail below.

Each cell 301 can include a pass gate transistor 320. Pass gate transistor 320 can include a channel region 323 between source/drain regions 321-322 and a gate 325 adjacent to channel region 323. Pass gate transistor 320 can be an N-type field effect transistor (NFET). That is, channel region 323 can be either an intrinsic channel region (i.e., an undoped channel region) or a P-type channel region with a relatively low conductivity level (i.e., a P- channel region). Source/drain region 321-322 can be an N-type source/drain region with a relatively high conductivity level (i.e., an N+ source/drain region).

Each cell 301 can also include only one antifuse and, particularly, either first antifuse 115a or second antifuse 115b of a DAF device 110B. Within each cell 301, pass gate transistor 320 can be electrically connected between the BL for the column containing the cell and the corresponding conductive region of the antifuse included in that cell (i.e., either the first conductive region 112a of a first antifuse 115a included in the cell or the second conductive region 112b of a second antifuse 115b included in the cell). Additionally, within each cell 301, gate 325 of pass gate transistor 320 and the corresponding conductor section of the antifuse included the cell (i.e., either the first conductor section 114a of a first antifuse 115a or the second conductor section 114b of a second antifuse 115b) can be connected to a WL for a row containing the cell. Furthermore, of the first and second antifuses 115a-115b of any particular DAF device 110B included in memory structure 300, first antifuse 115a is incorporated into one cell 301 in a column and second antifuse 115b is incorporated into the next cell down in the same column. Thus, first and second conductive regions 112a and 112b of first and second antifuses 115a and 115b of a DAF device 110B are connected by different pass gate transistors 320 of different cells 301 to the same BL for the same column, whereas first and second conductor sections 114a and 114b of first and second antifuses 115a and 115b of that same DAF device 110B are connected to two different WL for two adjacent rows.

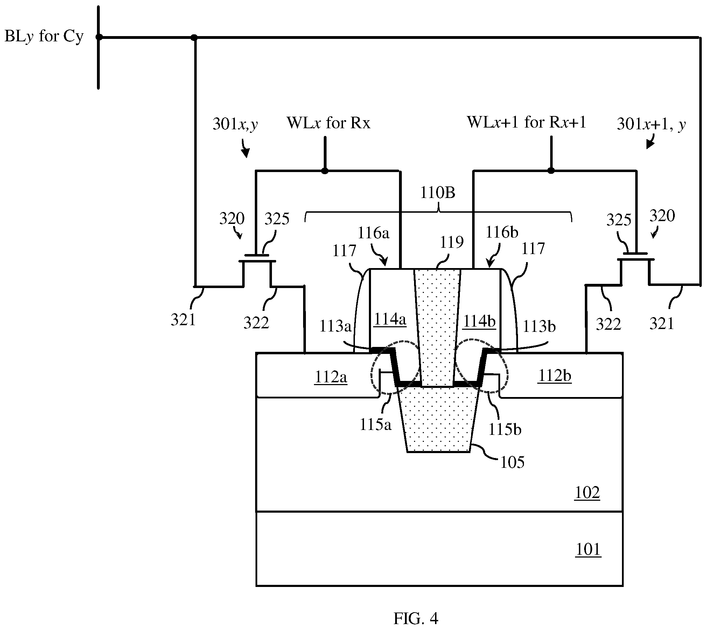

FIG. 4 shows a diagram illustrating in greater detail an example DAF device 110B incorporated into two different cells 301 within memory structure 300. As illustrated, a first cell 301*x,y* is located in column *y* at row *x* and a second cell 301*x*+1,*y* is also located in column *y*, but in the next row down (i.e., row *x*+1). In first cell 301*x,y*, pass gate transistor 320 has one source/drain region 321 electrically connected to BLy for Cy and another source/drain region 322 electrically connected first conductive region 112a of first antifuse 115a. Additionally, in first cell 301*x,y,* gate 325 of pass gate transistor 320 and first conductor section 114a of first antifuse 115a are electrically connected to WLx for Rx. In second cell 301*x*+1,*y*, pass gate transistor 320 has one source/drain region 321 electrically connected to BLy for Cy and another source/drain region 322 electrically connected second conductive region 112b of second antifuse 115b. Additionally, in second cell 301*x*+1,*y*, gate 325 of pass gate transistor 320 and second conductor section 114b of second antifuse 115b are electrically connected to WLx+1 for *Rx+1.*

Thus, referring again to FIG. 3, in each column, the bitline for the column is connectable by a pass gate transistor 320 of each cell 301 in that column to the corresponding conductive region 112a or 112b of the first or second antifuse 115a or 115b in the cell. In each row, the wordline for the row is electrically connected to the gates 325 of the pass gate transistors 320 of all cells in that row and also connected to the corresponding conductor sections of all antifuses of all cells in that row.

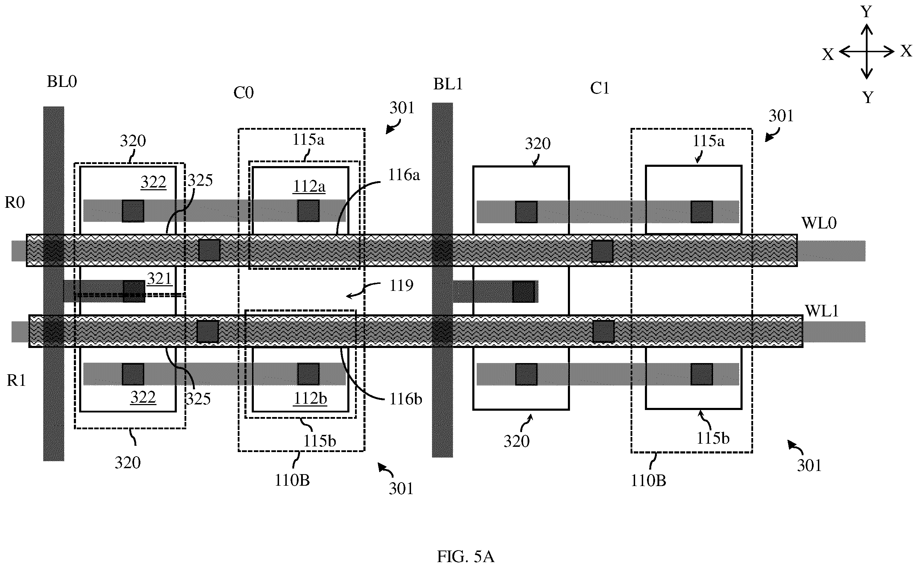

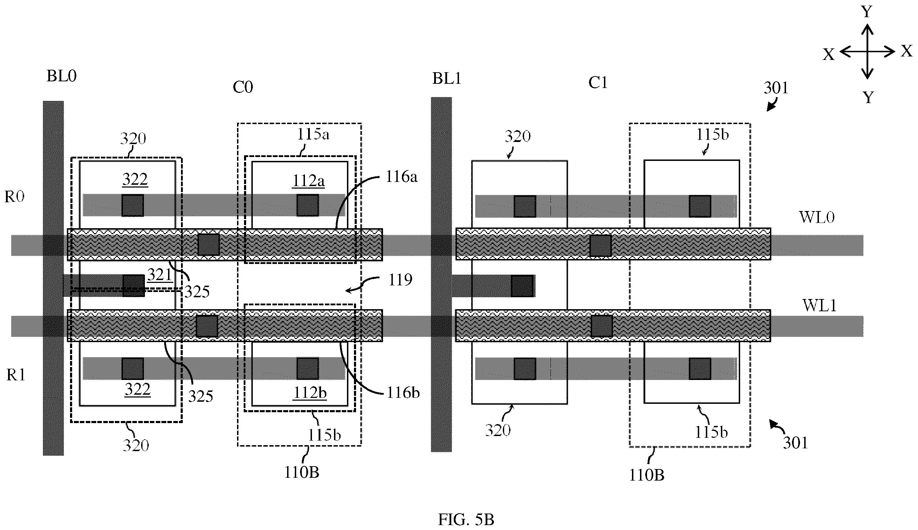

FIGs. 5A and 5B are diagrams illustrating alternative layouts, respectively, for cells 301 within memory structure 300 of FIG. 3. These layouts vary with regard to whether the gates 325 of the pass gate transistors 320 of the cells in each row are part of a continuous gate structure (e.g., as in FIG. 5A) or discrete gate structures (e.g., as in FIG. 5B). As illustrated in FIGs. 5A and 5B, each pair of adjacent cells (e.g., see the pair of adjacent cells at C0/R0 and C0/R1 and the pair of adjacent cells at C1/R0 and C1/R1) includes a shared DAF device 110B (as discussed above above). That is, in the pair of adjacent cells at C0/R0 and C0/R1, the cell at C0/R0 includes a first antifuse 115a of a DAF device 110B and the cell at C0/R1 includes a second antifuse 115b of the same DAF device 110B, and so on. Furthermore, in each pair of adjacent cells in a column, the pass gate transistors 320 of those adjacent cells can have a common source/drain region 321 connected to a bitline for the column. That is, in the pair of adjacent cells at C0/R0 and C0/R1, the cell in R0 and the cell in R1 can share a common source/drain region 321 connected to BL0, in the pair of adjacent cells at C1/R0 and C1/R1, the cell in R0 and the cell in R1 can share a common source/drain region 321 connected to BL1, and so on. With such layouts, the height of each cell 301 in memory structure 300 as measured in the Y direction (as indicated) can be significantly reduced as compared to the height of each cell in a memory structure where each cell includes both antifuses of a DAF device. As result of such size scaling in the Y direction, memory structure 300 may exhibit improved performance (e.g., due to both lower gate resistance (Rg) and lower gate capacitance (Cg) per cell).

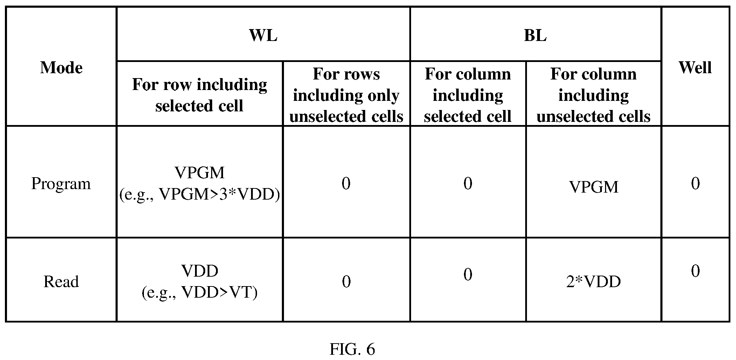

FIG. 6 is a table illustrating example wordline bias conditions and bitline bias conditions that can be applied to the WLs and BLs of memory structure 300 during: (a) a programming operation directed to the antifuse within a selected cell 301; and (b) a reading operation directed to the antifuse within a selected cell 301.

In the programming mode, a WL for a row containing a selected cell can be charged to a programming voltage (VPGM), whereas WLs for rows containing only unselected cells can be discharged to ground (e.g., biased to 0.0V). Additionally, a BL for a column containing the selected cell can be discharged to ground (e.g., biased to 0.0V), whereas BLs for columns containing only unselected cells can be charged to VPGM. Thus, only the pass gate transistor, which is electrically connected between a BL at 0.0V and an antifuse of the selected cell and which is controlled by a WL at VPGM, will turn on, thereby allowing current to flow therethrough in order to program the antifuse in the selected cell (e.g., due to a breakdown of the dielectric layer within the antifuse). All other pass gate transistors in all unselected cells remain off. It should be noted that VPGM can be relatively high and, particularly, at a level sufficient to cause breakdown of the dielectric layer in the antifuse in the selected cell.

In the reading mode, a WL for a row containing the selected cell can be charged to a read voltage. This read voltage can, for example, be equal to a positive supply voltage (VDD). VDD can be relatively low and, particularly, at or above the level of the threshold voltage (VT) of the pass gate transistor in each cell but sufficiently low to avoid breakdown of the antifuse dielectric layers. WLs for rows containing only unselected cells can be discharged to ground (e.g., biased to 0.0V). Additionally, a BL for a column containing the selected cell can be discharged to ground (e.g., biased to 0.0V), whereas BLs for columns containing only unselected cells can be charged to another positive voltage level between VDD and VPGM (e.g., to 2*VDD). Thus, during the reading operation, VDD is applied to one terminal of the antifuse of the selected cell and also to the gate of the pass gate transistor of the selected cell. Furthermore, the BL for the column containing the selected cell is at 0.0V and the BLs for the columns that do not contain the selected cell are at 2*VDD. Thus, only the pass gate transistor that is electrically connected between BL for the column containing the selected cell and the antifuse of the selected cell is turned on. During this reading operation, changes in an electrical parameter (e.g., current or voltage) on the BL that is electrically connected to the selected cell (via the pass gate transistor of the selected cell) will be indicative of a stored logic value. For example, if the antifuse in the selected cell has not been programmed (i.e., if it remains in a high resistance state), current flow through the antifuse will be blocked by the dielectric layer therein such that the voltage level on the BL will remain low (e.g., indicating a stored logic value of "0"). However, if the antifuse in the selected cell has been programmed (i.e., has been switched to a low resistance state), current will through the antifuse of the selected cell (due to breakdown of the dielectric layer therein) and the voltage level on the BL will be pulled up (e.g., indicating a stored logic value of "1"). It should be noted that, in some embodiments, VPGM could be 3 or more times greater than VDD. For example, in some embodiments, VDD=1.5V, 2*VDD=3.0V, and VPGM≥4.5V.

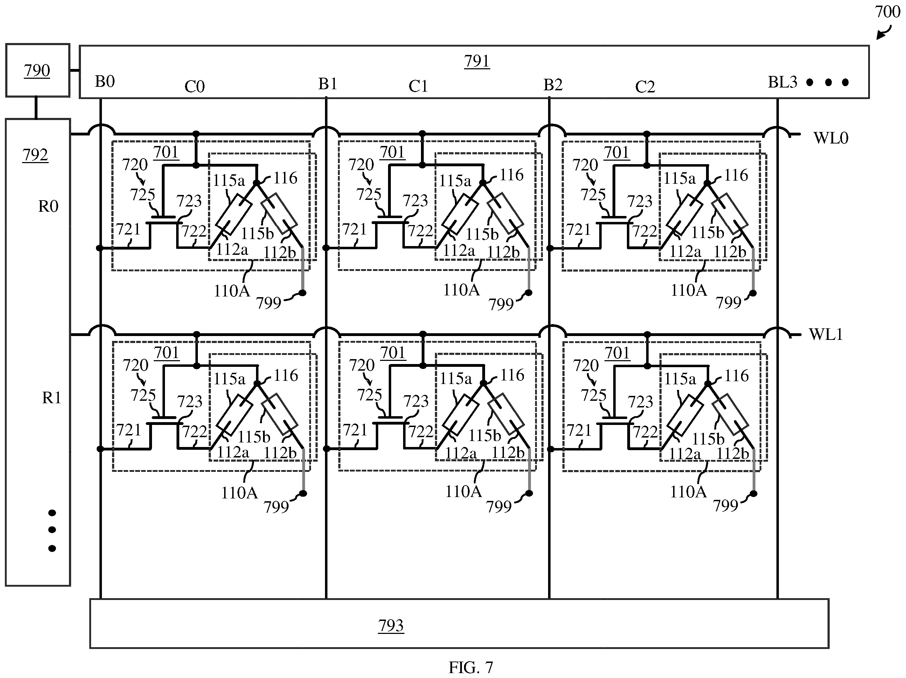

FIG. 7 is a schematic diagram illustrating disclosed embodiments of another memory structure 700, which includes multiple DAF devices 110A with antifuses that are electrically connected by a common terminal (e.g., as described above and illustrated in FIG. 1A). In these embodiments, the two antifuses of each DAF device 110A are within the same cell in an array but only one is operable (i.e., programmable or readable) thereby avoiding reliability issues exhibited in prior art memory structures.

Specifically, memory structure 700 can include: an array of memory cells 701 (hereinafter referred to as cells) arranged in rows (e.g., R0, R1, etc.) and columns (e.g., C0, C1, C2, etc.). Memory structure 700 can further include wordlines (e.g., W0, W1, etc.) for the rows, respectively; bitlines (e.g., BL0, BL1, BL2, etc.) for the columns, respectively; and multiple DAF devices 110A integrated into cells 701, as described in greater detail below.

Each cell 701 can include a pass gate transistor 720. Pass gate transistor 720 can include a channel region 723 between source/drain regions 721-722 and a gate 725 adjacent to channel region 723. Pass gate transistor 720 can be an N-type field effect transistor (NFET). That is, channel region 723 can be either an intrinsic channel region (i.e., an undoped channel region) or a P-type channel region with a relatively low conductivity level (i.e., a P- channel region). Source/drain region 721-722 can be an N-type source/drain region with a relatively high conductivity level (i.e., an N+ source/drain region).

Each cell 701 can also include a DAF device 110A, as illustrated in FIG. 1A and described in detail above. That is, DAF device 110A in each cell 701 can include a first antifuse 115a and a second antifuse 115b, which have a common first terminal (i.e., conductor layer 114 of gate structure 116 of DAF device 110A), and discrete second terminals (i.e., first conductive region 112a in first antifuse 115a of DAF device 110A and second conductive region 112b in second antifuse 115b of DAF device 110A).

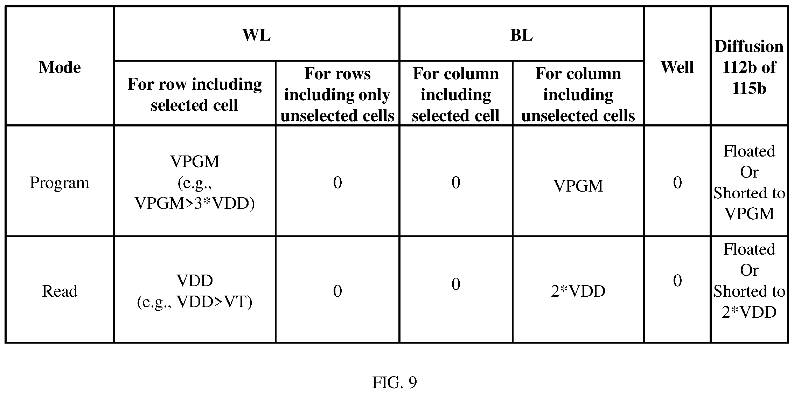

Within each cell 701, pass gate transistor 720 can be electrically connected between a BL for a column and the first conductive region 112a of the first antifuse 115a of the DAF device 110A. Additionally, both the gate 725 of pass gate transistor 720 and the common first terminal (i.e., conductor layer 114 of gate structure 116) of first and second antifuses 115a and 115b can be connected to a WL for a row. Furthermore, a second conductive region 112b of the second antifuse 115b in DAF device 110A can be floated (i.e., not electrically connected to any other component in the memory structure 700). Alternatively, the second conductive region 112b can be electrically connected to a common node 799 and thereby shorted to other second terminals of other second antifuses of other DAF devices of other cells within memory structure 700. For example, in some embodiments, all second conductive regions 112b of all second antifuses 115b of all DAF devices 110A in all cells in memory structure 700 can be shorted together and biased with the same operation-dependent bias voltage (as discussed in greater detail below with regard to the table of FIG. 9). Thus, in each cell 701, second antifuse 115b of the DAF device 110A is effectively inoperable (i.e., not programmable and not readable).

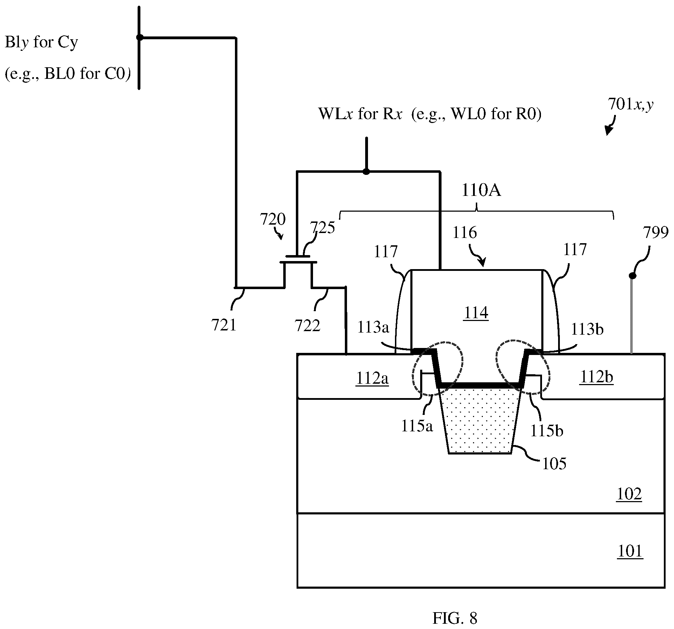

FIG. 8 shows a diagram of an example cell 701*x,y* within memory structure 700. Cell 701*x,y* can be located in a row *x* and a column *y*. In cell 701*x,y,* pass gate transistor 720 has one source/drain region 721 electrically connected to BLy for Cy and another source/drain region 722 electrically connected to first conductive region 112a of first antifuse 115a. Additionally, gate 725 of pass gate transistor 720 and conductor layer 114 of gate structure 116 (i.e., common first terminal of first and second antifuses 115a-115b) are both electrically connected to WLx for Rx. Finally, second conductive region 112b of second antifuse 115b can be either left floating (i.e., not electrically connected to any other components) or connected to common node 799 so as to be shorted to one or more other second conductive regions of one or more other second antifuses of one or more other DAF devices of one or more other cells.

FIG. 9 is a table illustrating example wordline bias conditions and bitline bias conditions that can be applied to WLs and BLs of memory structure 700 during: (a) a programming operation directed to a first antifuse 115a within a selected cell 701; and (b) a reading operation directed to a first antifuse 115a within a selected cell 701.

In the programming mode, WL for the row containing the selected cell can be charged to a programming voltage (VPGM), whereas WLs for rows containing only unselected cells can be discharged to ground (e.g., biased to 0.0V). Additionally, BL for the column containing the selected cell can be discharged to ground (e.g., biased to 0.0V), whereas BLs for the columns containing only unselected cells can be charged to VPGM. Thus, only a pass gate transistor connected between a BL for a column containing a selected cell and the first antifuse of the selected cell will turn on, thereby allowing current to flow to program the first antifuse of the selected cell (due to a breakdown of the dielectric layer within that first antifuse). All other pass gate transistors remain off. It should be noted that VPGM can be relatively high and, particularly, at a level sufficient to cause breakdown of the dielectric layer in the first antifuse in the selected cell. In embodiments where second conductive regions 112b of second antifuses 115b are shorted together (e.g., connected to a common node 799) (as opposed to being left floating), common node 799 can, for example, be connected to receive VPGM during the programming mode.

In the reading mode, WL for the row containing the selected cell can be charged to a read voltage. This read voltage can, for example, be equal to a positive supply voltage (VDD). VDD can be relatively low and, particularly, at or above the level of the threshold voltage (VT) of the pass gate transistor in each cell but sufficiently low to avoid breakdown of the antifuse dielectric layers. WLs for rows containing only unselected cells can be discharged to ground (e.g., biased to 0.0V). Additionally, BL for the column containing the selected cell can be discharged to ground (e.g., bias to 0.0V), whereas BLs for columns containing only unselected cells can be charged to another positive voltage level between VDD and VPGM (e.g., to 2*VDD).

Thus, during the reading operation, VDD is applied to the first antifuse of the selected cell and to the gate of the pass gate transistor of the selected cell. Furthermore, BL for the column containing the selected cell is at 0.0V and BLs for columns that do not contain the selected cell are at 2*VDD. Thus, only the pass gate transistor between BL for the column containing the selected cell and the first antifuse therein is turned on. During this reading operation, changes in an electrical parameter (e.g., current or voltage) on BL connected to the selected cell will be indicative of a stored logic value. For example, if the first antifuse in the selected cell has not been programmed (i.e., if it remains in a high resistance state), current flow to the bitline will be blocked such that the voltage level on the bitline remains low (e.g., indicating a stored logic value of "0"). However, if the first antifuse in the selected cell has been programmed (i.e., has been switched to a low resistance state), current will flow through the first antifuse and pass gate transistor to the BL and the voltage level on the BL will be pulled up (e.g., indicating a stored logic value of "1"). It should be noted that, in some embodiments, VPGM could be 3 or more times greater than VDD. For example, in some embodiments, VDD=1.5V, 2*VDD=3.0V, and VPGM≥4.5V. In embodiments where second conductive regions 112b of second antifuses 115b are shorted together (e.g., connected to a common node 799) (as opposed to being left floating), common node 799 can, for example, be connected to receive 2*VDD during the reading mode.

In addition to the features described above, memory structure 300 of FIG. 3 and memory structure 700 of FIG. 7 can each include additional circuitry to facilitate performance of the above-described memory operations. Specifically, memory structure 300, 700 can include: a controller 390, 790; and peripheral circuitry 391-393, 791-793, which is in communication with controller 390, 790, is connected to the WLs and BLs of the array, and which is configured to facilitate memory cell operations (e.g., one-time programming operations and repeated reading operations) in response to control signals from the controller 390, 790. The peripheral circuitry can include a row control block 392, 792. which is electrically connected to the wordlines (WL0, WL1, etc.) for the rows (R0, R1, etc.). Row control block 392, 792 can be a conventional row control block, which includes row address decode logic, voltage drivers, etc., for biasing the wordlines, as described above. The peripheral circuitry can also include a column control block 391, 791, which is electrically connected to the bitlines (BL0, BL1, BL2, etc.) for the columns (C0, C1, C2, etc.). Column control block 391, 791 can include column address decode logic, voltage drivers, etc. for biasing the bitlines, as described above. The peripheral circuitry can further include a sense circuit 393, 793, which is electrically connected to the bitlines (BL0, BL1, BL2, etc.). Sense circuit 393, 793 can be configured to sense electrical parameter changes (e.g., voltage changes or current changes) on BLs during reading operations. Memory controllers, row control blocks, column control blocks, and sense circuits are well known in the art. Thus, the details thereof have been omitted from this specification in order to allow the reader to focus on the salient aspects of the disclosed embodiments related to the overall memory cell configuration, memory array configuration, and operating method.

It should be understood that in the method and structures described above, a semiconductor material refers to a material whose conducting properties can be altered by doping with an impurity. Examples of semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. **In** the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

Disclosed is a dual-antifuse (DAF) device with two electrically isolated antifuses. The DAF device includes a gate structure including a dielectric layer lining a recess in a semiconductor layer between first and second conductive regions and a conductor layer on the dielectric layer. A gate cut isolation structure extends through the conductor layer, dividing the conductor layer into first and second conductor sections. As a result, the device includes a first antifuse (i.e., the first conductor section, the first conductive region, and the dielectric layer therebetween) and a second antifuse (i.e., a second conductor section, the second conductive region, and the dielectric layer therebetween), which is isolated from the first antifuse. Thus, the two antifuses are independently programable. Also disclosed herein are memory structure embodiments, which include DAF devices (either with or without electrically isolated antifuses) integrated into the cells of an array and which are configured for improved reliability.

The following embodiments are explicitly disclosed.

### Embodiment 1:

A structure comprising:
a semiconductor layer having a top surface and a recess in the top surface;
a trench isolation structure in the semiconductor layer below the recess; and
a gate structure on the trench isolation structure, wherein the gate structure includes a dielectric layer lining the recess and, on the dielectric layer, a first conductor section and a second conductor section positioned laterally adjacent and isolated from the first conductor section.

### Embodiment 2:

The structure of embodiment 1, wherein the gate structure includes:
a conductor layer on the dielectric layer; and
a gate cut isolation structure extending through the conductor layer and dividing the conductor layer into the first conductor section and the second conductor section isolated from the first conductor section.

### Embodiment 3:

The structure of embodiment 2, wherein the conductor layer includes any of a doped polycrystalline semiconductor layer and a metallic layer.

### Embodiment 4:

The structure of one of embodiments 1 to 3,
wherein the semiconductor layer further includes a first conductive section and a second conductive section, and
wherein the recess is positioned laterally between and immediately adjacent the first conductive section and the second conductive section.

### Embodiment 5:

The structure of embodiment 4, further comprising: a well region, wherein the first conductive region, the trench isolation structure, and the second conductive region are within the well region, wherein the first conductive region and the second conductive region have a same type conductivity, and wherein the well region has a different type conductivity than the first conductive region and the second conductive region.

### Embodiment 6:

The structure of embodiment 4 or 5, wherein the gate structure extends laterally onto a top surface of the semiconductor layer partially over the first conductive region and the second conductive region.

### Embodiment 7:

The structure of one of embodiments 4 to 6, further comprising:
a first antifuse including the first conductor section, the first conductive region, and a first portion of the dielectric layer between the first conductor section and the first conductive region; and
a second antifuse including the second conductor section, the second conductive region, and a second portion of the dielectric layer between the second conductor section and the second conductive region.

### Embodiment 8:

The structure of embodiment 7, wherein the first antifuse and the second antifuse are independently programmable.

### Embodiment 9:

The structure of one of embodiments 1 to 8, further comprising gate sidewall spacers on the top surface of the semiconductor layer positioned laterally adjacent to the gate structure.

### Embodiment 10:

A structure comprising:
an array of cells arranged in rows and columns;
wordlines for the rows, respectively;
bitlines for the columns, respectively; and
multiple dual-antifuse devices,
wherein each cell includes: a pass gate transistor; and one antifuse of a dual-antifuse device of the dual-antifuse devices,
wherein, within each cell, the one antifuse is connected between a wordline for a row and the pass gate transistor, and
wherein, within each cell, the pass gate transistor is connected between the one antifuse and a bitline for a column and further has a gate connected to the wordline for the row.

### Embodiment 11:

The structure of embodiment 10,
wherein each dual-antifuse device is individually programmable and further includes:
   a gate structure including:
      a dielectric layer lining a recess in a semiconductor layer between a first conductive region and a second conductive region; and
      a conductor layer on the dielectric layer; and
   a gate cut isolation structure extending through the conductor layer and dividing the conductor layer into a first conductor section and a second conductor section, wherein the two antifuses include:
      a first antifuse including the first conductor section, the first conductive region, and a first portion of the dielectric layer between the first conductor section and the first conductive region; and
      a second antifuse including the second conductor section, the second conductive region, and a second portion of the dielectric layer between the second conductor section and the second conductive region, and
wherein, within each cell, a corresponding conductor section of the one antifuse is connected to the wordline for the row and a corresponding conductive region of the one antifuse is connected to the pass gate transistor.

### Embodiment 12:

The structure of embodiment 11, wherein, within each column, pairs of adjacent cells, have a shared dual-antifuse device and pass gate transistors with a common source/drain region connected to the bitline for the column.

### Embodiment 13:

The structure of embodiment 11 or 12, wherein, within each row, all antifuses of all cells have corresponding conductor sections connected to a wordline for the row.

### Embodiment 14:

The structure of one of embodiments 11 to 13,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

### Embodiment 15:

The structure of one of embodiments 11 to 14, wherein each dual-antifuse device further includes gate sidewall spacers above the first conductive region and the second conductive region and positioned laterally adjacent opposing sidewalls of the gate structure.

### Embodiment 16:

A structure comprising:
an array of cells arranged in rows and columns;
wordlines for the rows, respectively;
bitlines for the columns, respectively; and
multiple dual-antifuse devices,
wherein each cell includes: a dual-antifuse device of the multiple dual-antifuse devices; and a pass gate transistor,
wherein, within each cell, the dual-antifuse device includes a first antifuse connected between a wordline for a row and the pass gate transistor and a second antifuse with a first terminal connected to the wordline for the row and a second terminal that is any of floated and connected to a common node, and
wherein, within each cell, the pass gate transistor is connected between the first antifuse and a bitline for a column and further has a gate connected to the wordline for the row.

### Embodiment 17:

The structure of embodiment 16,
wherein each dual-antifuse device is individually programmable and includes:
   a gate structure including:
   a dielectric layer lining a recess in a semiconductor layer between a first conductive region and a second conductive region; and
   a conductor layer on the dielectric layer, and
wherein the conductor layer is a shared first terminal of the first antifuse and the second antifuse,
wherein the first antifuse includes the conductor layer, the first conductive region, and a first portion of the dielectric layer between the conductor layer and the first conductive region,
wherein the second antifuse includes the conductor layer, the second conductive region, and a second portion of the dielectric layer between the conductor layer and the second conductive region, and
wherein, within each cell, the pass gate transistor is connected between the bitline for the column and the first conductive region of the first antifuse of the dual-antifuse device and the conductor layer of the gate structure of the dual-antifuse device is connected to the wordline for the row.

### Embodiment 18:

The structure of embodiment 17, wherein, within each cell, the second conductive region is the second terminal of the second antifuse.

### Embodiment 19:

The structure of embodiment 17 or 18,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

### Embodiment 20:

The structure of one of embodiments 17 to 19, wherein each dual-antifuse device further includes gate sidewall spacers above the first conductive region and the second conductive region and positioned laterally adjacent opposing sidewalls of the gate structure.

### Embodiment 21:

A structure comprising:
an array of cells arranged in rows and columns;
wordlines for the rows, respectively;
bitlines for the columns, respectively; and
multiple dual-antifuse devices,
wherein each cell includes: a pass gate transistor; and a first antifuse of a dual-antifuse device of the multiple dual-antifuse devices,
wherein, within each cell, the first antifuse is connected between a wordline for a row and the pass gate transistor, and
wherein, within each cell, the pass gate transistor is connected between the first antifuse and a bitline for a column and further has a gate connected to the wordline for the row.

### Embodiment 22:

The structure of embodiment 21, wherein each cell further includes a second antifuse such that each cell includes: a dual-antifuse device of the multiple dual-antifuse devices; and the pass gate transistor,
wherein, within each cell, the dual-antifuse device includes the first antifuse connected between the wordline for a row and the pass gate transistor and the second antifuse with a first terminal connected to the wordline for the row and a second terminal that is any of floated and connected to a common node.

### Embodiment 23:

The structure of embodiment 21,
wherein each dual-antifuse device is individually programmable and further includes:
   a gate structure including:
      a dielectric layer lining a recess in a semiconductor layer between a first conductive region and a second conductive region; and
      a conductor layer on the dielectric layer; and
   a gate cut isolation structure extending through the conductor layer and dividing the conductor layer into a first conductor section and a second conductor section, wherein the two antifuses include:
      the first antifuse including the first conductor section, the first conductive region, and a first portion of the dielectric layer between the first conductor section and the first conductive region; and
      a second antifuse including the second conductor section, the second conductive region, and a second portion of the dielectric layer between the second conductor section and the second conductive region, and
wherein, within each cell, a corresponding conductor section of the first antifuse is connected to the wordline for the row and a corresponding conductive region of the first antifuse is connected to the pass gate transistor.

### Embodiment 24:

The structure of embodiment 22,
wherein each dual-antifuse device is individually programmable and includes:
   a gate structure including:
      a dielectric layer lining a recess in a semiconductor layer between a first conductive region and a second conductive region; and
      a conductor layer on the dielectric layer, and
wherein the conductor layer is a shared first terminal of the first antifuse and the second antifuse,
wherein the first antifuse includes the conductor layer, the first conductive region, and a first portion of the dielectric layer between the conductor layer and the first conductive region,
wherein the second antifuse includes the conductor layer, the second conductive region, and a second portion of the dielectric layer between the conductor layer and the second conductive region, and
wherein, within each cell, the pass gate transistor is connected between the bitline for the column and the first conductive region of the first antifuse of the dual-antifuse device and the conductor layer of the gate structure of the dual-antifuse device is connected to the wordline for the row,
wherein, within each cell, the second conductive region is preferably the second terminal of the second antifuse.

### Embodiment 25:

The structure of one of embodiments 23 or 24, wherein, within each column, pairs of adjacent cells, have a shared dual-antifuse device and pass gate transistors with a common source/drain region connected to the bitline for the column, and/or
wherein, within each row, all antifuses of all cells have corresponding conductor sections connected to a wordline for the row.

### Embodiment 26:

The structure of one of embodiments 23 to 25,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

### Embodiment 27:

The structure of one of embodiments 23 to 26, wherein each dual-antifuse device further includes gate sidewall spacers above the first conductive region and the second conductive region and positioned laterally adjacent opposing sidewalls of the gate structure.

### Embodiment 28:

The structure of one of embodiments 23 to 27,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

### Embodiment 29:

The structure of one of embodiments 23 to 28, wherein each dual-antifuse device further includes gate sidewall spacers above the first conductive region and the second conductive region and positioned laterally adjacent opposing sidewalls of the gate structure.

In any of the embodiments 10 to 29 above, the structure may be a memory structure. Such a memory structure may include multiple dual-antifuse devices.

In the disclosure herein, the terms "include" and "comprise" may be synonymous.

## Claims

1. A structure comprising:
a semiconductor layer having a top surface and a recess in the top surface;
a trench isolation structure in the semiconductor layer below the recess; and
a gate structure on the trench isolation structure, wherein the gate structure includes a dielectric layer lining the recess and, on the dielectric layer, a first conductor section and a second conductor section positioned laterally adjacent and isolated from the first conductor section.

2. The structure of claim 1, wherein the gate structure includes:
a conductor layer on the dielectric layer; and
a gate cut isolation structure extending through the conductor layer and dividing the conductor layer into the first conductor section and the second conductor section isolated from the first conductor section,
wherein the conductor layer preferably includes any of a doped polycrystalline semiconductor layer and a metallic layer.

3. The structure of claim 1 or 2,
wherein the semiconductor layer further includes a first conductive section and a second conductive section, and
wherein the recess is positioned laterally between and immediately adjacent the first conductive section and the second conductive section,
wherein the gate structure preferably extends laterally onto a top surface of the semiconductor layer partially over the first conductive region and the second conductive region.

4. The structure of claim 3, further comprising: a well region, wherein the first conductive region, the trench isolation structure, and the second conductive region are within the well region, wherein the first conductive region and the second conductive region have a same type conductivity, and wherein the well region has a different type conductivity than the first conductive region and the second conductive region.

5. The structure of claim 3 or 4, further comprising:
a first antifuse including the first conductor section, the first conductive region, and a first portion of the dielectric layer between the first conductor section and the first conductive region; and
a second antifuse including the second conductor section, the second conductive region, and a second portion of the dielectric layer between the second conductor section and the second conductive region,
wherein the first antifuse and the second antifuse are preferably independently programmable.

6. The structure of one of claims 1 to 5, further comprising gate sidewall spacers on the top surface of the semiconductor layer positioned laterally adjacent to the gate structure.

7. A structure comprising:
an array of cells arranged in rows and columns;
wordlines for the rows, respectively;
bitlines for the columns, respectively; and
multiple dual-antifuse devices,
wherein each cell includes: a pass gate transistor; and a first antifuse of a dual-antifuse device of the multiple dual-antifuse devices,
wherein, within each cell, the first antifuse is connected between a wordline for a row and the pass gate transistor, and
wherein, within each cell, the pass gate transistor is connected between the first antifuse and a bitline for a column and further has a gate connected to the wordline for the row.

8. The structure of claim 7, wherein each cell further includes a second antifuse such that each cell includes: a dual-antifuse device of the multiple dual-antifuse devices; and the pass gate transistor,
wherein, within each cell, the dual-antifuse device includes the first antifuse connected between the wordline for a row and the pass gate transistor and the second antifuse with a first terminal connected to the wordline for the row and a second terminal that is any of floated and connected to a common node.

9. The structure of claim 7,
wherein each dual-antifuse device is individually programmable and further includes:
a gate structure including:
a dielectric layer lining a recess in a semiconductor layer between a first conductive region and a second conductive region; and
a conductor layer on the dielectric layer; and
a gate cut isolation structure extending through the conductor layer and dividing the conductor layer into a first conductor section and a second conductor section, wherein the two antifuses include:
the first antifuse including the first conductor section, the first conductive region, and a first portion of the dielectric layer between the first conductor section and the first conductive region; and
a second antifuse including the second conductor section, the second conductive region, and a second portion of the dielectric layer between the second conductor section and the second conductive region, and
wherein, within each cell, a corresponding conductor section of the first antifuse is connected to the wordline for the row and a corresponding conductive region of the first antifuse is connected to the pass gate transistor.

10. The structure of claim 8,
wherein each dual-antifuse device is individually programmable and includes:
a gate structure including:
a dielectric layer lining a recess in a semiconductor layer between a first conductive region and a second conductive region; and
a conductor layer on the dielectric layer, and
wherein the conductor layer is a shared first terminal of the first antifuse and the second antifuse,
wherein the first antifuse includes the conductor layer, the first conductive region, and a first portion of the dielectric layer between the conductor layer and the first conductive region,
wherein the second antifuse includes the conductor layer, the second conductive region, and a second portion of the dielectric layer between the conductor layer and the second conductive region, and
wherein, within each cell, the pass gate transistor is connected between the bitline for the column and the first conductive region of the first antifuse of the dual-antifuse device and the conductor layer of the gate structure of the dual-antifuse device is connected to the wordline for the row,
wherein, within each cell, the second conductive region is preferably the second terminal of the second antifuse.

11. The structure of claim 9 or 10, wherein, within each column, pairs of adjacent cells, have a shared dual-antifuse device and pass gate transistors with a common source/drain region connected to the bitline for the column, and/or
wherein, within each row, all antifuses of all cells have corresponding conductor sections connected to a wordline for the row.

12. The structure of one of claims 9 to 11,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

13. The structure of one of claims 9 to 12, wherein each dual-antifuse device further includes gate sidewall spacers above the first conductive region and the second conductive region and positioned laterally adjacent opposing sidewalls of the gate structure.

14. The structure of one of claims 9 to 13,
wherein, within each dual-antifuse device, a trench isolation structure is within the semiconductor layer below the recess,
wherein the first conductive region, the trench isolation structure, and the second conductive region are within a well region,
wherein the first conductive region and the second conductive region have a same type conductivity, and
wherein the well region has a different type conductivity than the first conductive region and the second conductive region.

15. The structure of one of claims 9 to 14, wherein each dual-antifuse device further includes gate sidewall spacers above the first conductive region and the second conductive region and positioned laterally adjacent opposing sidewalls of the gate structure.
